# EUROPÄISCHE PATENTSCHRIFT

(11) **EP 1 202 024 B1**
(45) Veröffentlichungstag und Bekanntmachung des Hinweises auf die Patenterteilung: **23.03.2005**
(21) Anmeldenummer: 01125622.9
(22) Anmeldetag: 26.10.2001
(51) Int. Cl.: G01B 7/00, G01D 5/16, G01P 3/488, H01L 25/10, H05K 1/18, F02D 9/10

(54) **Sensormodul mit Blechformteil ( magnetoresistiver Drosselklappensensor )**
Sensor module with stamped sheet metal part ( magneto resistive throttle valve sensor )
Module de capteur avec une plaque de métal découpée ( capteur magnéto résistif vanne papillon )

(30) Priorität: 27.10.2000 DE 20018538 U
(43) Veröffentlichungstag der Anmeldung: 02.05.2002
(73) Patentinhaber: SIEMENS AKTIENGESELLSCHAFT, 80333 München (DE)
(72) Erfinder: Dammköhler, Jörg, Dr., 65779 Kelkheim (DE); Degen, Martin, 61352 Bad Homburg (DE); Kern, Eckhart, 65719 Hofheim (DE); Porth, Wolfgang, 60388 Frankfurt (DE)

(56) Entgegenhaltungen:
- EP-A- 1 022 568
- WO-A-96/02848
- DE-A- 4 123 407
- DE-A- 19 747 177
- US-A- 4 495 546
- US-A- 5 508 563
- IBM CORP.: "Stackable Flex Packaging of Chips" IBM TDB, Bd. 38, Nr. 06, 1. Juni 1995 (1995-06-01), Seiten 1-2, XP000520556 New Armonk, NY (US)
- KLAUS C.J. DIETMAYER: "Magnetische Sensoren auf Basis des AMR-Effekts" TECHNISCHES MESSEN, Bd. 68, Nr. 6, 1. Juni 2001 (2001-06-01), Seiten 269-279, XP002188979 München (DE)

## Beschreibung

Die Erfindung betrifft ein Sensormodul, bei welchem ein Positionssensor mit einer Auswerteelektronik verbunden ist, die das von dem Positionssensor abgegebene, der Lage eines zu überwachenden Bauteiles entsprechende Signal aufbereitet.

Bei bekannten Sensoren wird das von dem Sensor abgegebene Signal einer Auswerteelektronik zugeführt, welche das Sensorsignal zur weiteren Verarbeitung durch eine angeschlossene Elektronik aufbereitet. So wird beispielsweise das Signal eines in einem Kraftfahrzeug angeordneten Positionssensors, welches die Veränderung der Position eines zu überwachenden Bauteiles, wie die Drosselklappe, repräsentiert, an eine Motorsteuerelektronik weitergeleitet, die auf der Grundlage des Sensorsignales ein Steuersignal für die Ansteuerung des Verbrennungsmotors erzeugt.

In der Auswerteelektronik wird das Sensorsignal verstärkt und gewandelt und ein nullpunkt- und/oder temperaturkorrigiertes Ausgangssignal erzeugt.

Beim Einbau des Sensors und der Auswerteelektronik müssen beide aufeinander abgestimmt werden. Nach einem Vorabgleich beim jeweiligen Hersteller müssen die beiden Einzelteile beim Einbau in das Gerät, welches das positionsüberwachende Bauteil enthält, noch einmal aufeinander abgestimmt werden. Ein solcher Abgleich ist sehr aufwendig. Die örtliche Trennung von Sensor und Auswerteelektronik erfordert zusätzlichen Leitungsaufwand.

Der Erfindung liegt somit die Aufgabe zugrunde, eine Sensoranordnung anzugeben, welche einfach und mit reduziertem Abgleichaufwand herstellbar ist.

Erfindungsgemäß wird die Aufgabe dadurch gelöst, dass der Positionssensor und die Auswerteelektronik gemeinsam an oder auf einem Blechformteil angeordnet sind, wobei das Blechformteil mindestens zwischen Sensor und Auswerteelektronik zu deren elektrischer Verbindung als Leiterbahnstruktur ausgebildet ist, welche zur Anpassung an den Einbauort des Sensors abgewinkelt ist.

Der Vorteil der Erfindung besteht darin, dass durch die Anordnung auf einem Blechformteil eine genaue Plazierung des Sensors an dem zu überwachenden Bauteil möglich ist. Auf Leitungsverbindungen zwischen Sensor und Auswerteelektronik kann verzichtet werden, wodurch die Bauform des Moduls verkleinert wird. Sensor und Auswerteelektronik werden in einem Schritt gemeinsam abgeglichen. Ein so geschaffenes Positionssensormodul ist nicht nur einfach im Offset und Meßbereich programmierbar, sondern kann auch zu Diagnosezwekken verwendet werden, wie beispielsweise zur Feststellung eines Leitungsbruchs oder Kurzschlusses zwischen Sensor und Auswerteelektronik. Durch Verbiegen des Blechformteils, im Bereich der Verbindung zwischen Sensor und Auswerteelektronik, kann das Sensormodul einer beliebigen Einbaugeometrie angepaßt werden.

In einer bevorzugten Ausführuhgsform ist der Sensor als magnetoresistiver Sensor ausgebildet, welcher in einem Magnetfeld angeordnet ist.

Vorteilhafterweise ist der Sensor annähernd im Zentrum eines zylinderförmig ausgebildeten Dauermagneten angeordnet. Durch die Abwinklung des Blechformteiles ist eine genaue Plazierung des Sensors im homogenen Teil des Magnetfeldes möglich.

Bei einer vorteilhaften Ausgestaltung ist der Sensor an einem ersten äußeren Ende des Blechformteiles arretiert, wobei das die Auswerteelektronik in eine dem Sensor entgegengesetzte Richtung überragende Ende des Blechformteiles von mindestens einer frei endenden Leiterbahn des Blechformteiles gebildet ist. Auf diese Art und Weise ist ein einfacher elektrischer Anschluß des Blechformteiles an andere elektrische Schaltungen möglich.

In einer Weiterbildung der Erfindung ist das freie Ende des Blechformteiles elektrisch mit einem zweiten, passive elektrische Bauelemente tragenden Blechformteil verbunden, an welchem die Kontakteinrichtung ausgeformt ist. Aufgrund der Verwendung von Blechformteilen können für den konkreten Einsatzfall notwendige Bauelemente auf diesem angeordnet und elektrisch über das Blechformteil miteinander verbunden werden und bilden somit eine kompakte Einrichtung, welche insbesondere für den Einsatz in Kraftfahrzeugen erschütterungsfrei gelagert ist. Diese beiden Blechformteile können mit üblichen Verbindungstechniken, wie Schweißen oder Löten, kontaktiert werden, sowie zum Schutz vor korrosiven Einflüssen umspritzt, vergossen oder gehäust werden.

Vorteilhafterweise können die Kontakteinrichtung oder das freie Ende der Leiterbahn selbst als Steckeinrichtung ausgebildet sein, wodurch auf das Befestigen eines separaten Steckers verzichtet werden kann.

Zum Schutz des Sensors bzw. der Auswerteelektronik beim Einbau in den Einsatzort, beispielsweise in ein Kraftfahrzeug sind der Sensor und die Auswerteelektronik separat gehäust.

Zur Herstellung redundanter Ausgangssignale liefernden Positionssensormoduls sind eine erste und eine zweite identisch aufgebaute, jeweils aus einem Sensor, einem Blechformteil und einer Auswerteelektronik bestehende Sensoreinheit vorhanden, wobei das Blechformteil jeder Sensoreinheit zwischen Sensor und Auswerteelektronik annähernd um 90 Grad abgewinkelt ist und die beiden Sensoreinheiten so in dem zylindrisch ausgebildeten Magneten eingeführt sind, dass die Sensoren unmittelbar übereinander liegend angeordnet sind, während die Auswerteelektroniken der beiden Sensoreinheiten sich gegenüber liegend jeweils dezentral, außerhalb der Sensorabmessungen angeordnet sind.

Die Erfindung läßt zahlreiche Ausführungsformen zu. Eine davon soll anhand der in der Zeichnung dargestellten Figuren näher erläutert werden.

Es zeigen:
- Fig. 1:: Eine nicht beanspruchte Ausführungsform eines Positionssensormodules
- Fig. 2:: erste Ausführung des erfindungsgemäßen Positionssensormodules
- Fig. 3:: zweite Ausführungsform des erfindungsgemäßen Positionssensormodules

Gleiche Merkmale sind mit gleichen Bezugszeichen gekennzeichnet.

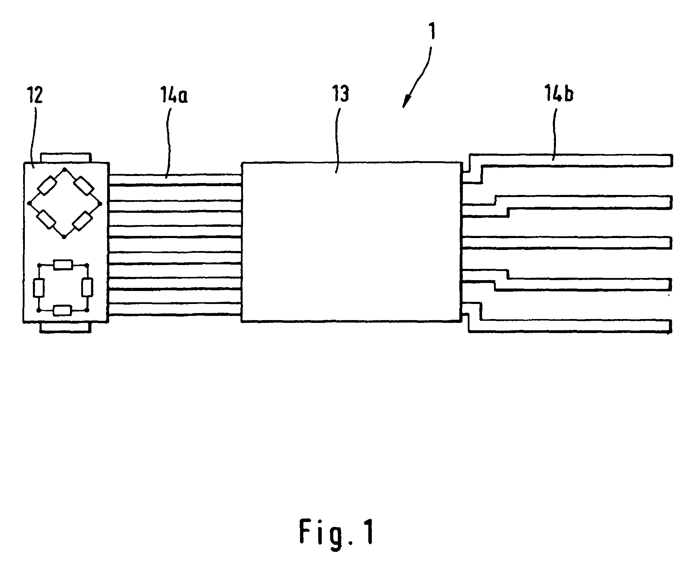

Figur 1 zeigt ein Sensormodul 1, welches aus einem magnetoresistiven Sensor 12 und einer Auswerteschaltung 13 besteht. Der Sensor 12 ist am Ende einer Leadframe-Anordnung 14 angeordnet, welche vorzugsweise ein Feinstanzrahmen ist. Über die Finger 14a der Leadframe-Anordnung 14 ist der Sensor 12 mit der Auswerteschaltung 13 verbunden. Über die aus der Auswerteschaltung 13 entgegengesetzt zum Sensor 12 herausragenden freien Enden 14b der Leadframe-Anordnung 14 ist die Auswerteschaltung 13 mit anderen elektronischen Schaltungseinrichtungen verbindbar.

Die aus den Sensorgehäusen 12 und 22 seitlich herausragenden Bestandteile 15 und 25 der Lead-Frame-Anordnung 14 dienen als Markierungen zur exakten Positionierung des Sensormoduls 1 im Meßfeld.

Der Sensor 12 ist als magnetoresistiver Winkelsensor ausgebildet und besteht aus zwei Widerstandsbrücken, deren sinusförmige Ausgangssignale um 90 Grad phasenverschoben sind. Die Auswerteelektronik 13 bestimmt die Winkelposition und ermöglicht gleichzeitig eine Offsetkompensation des Winkelsensors.

Zwischen dem mit einem Gehäuse versehenen Sensor 12 und der ebenfalls separat gehäusten Auswerteelektronik 13 sind bei der vorliegenden Ausführungsform sechs Verbindungen 14a vorgesehen, während die Auswerteelektronik 13 fünf Ausgangsanschlüsse 14b zur Kommunikation mit externen Einrichtungen aufweist. Über die Leadframe-Verbindungen 14a und 14b werden sowohl Sensorsignale, Steuersignale als auch Leistungssignale, wie die Betriebsspannung übertragen.

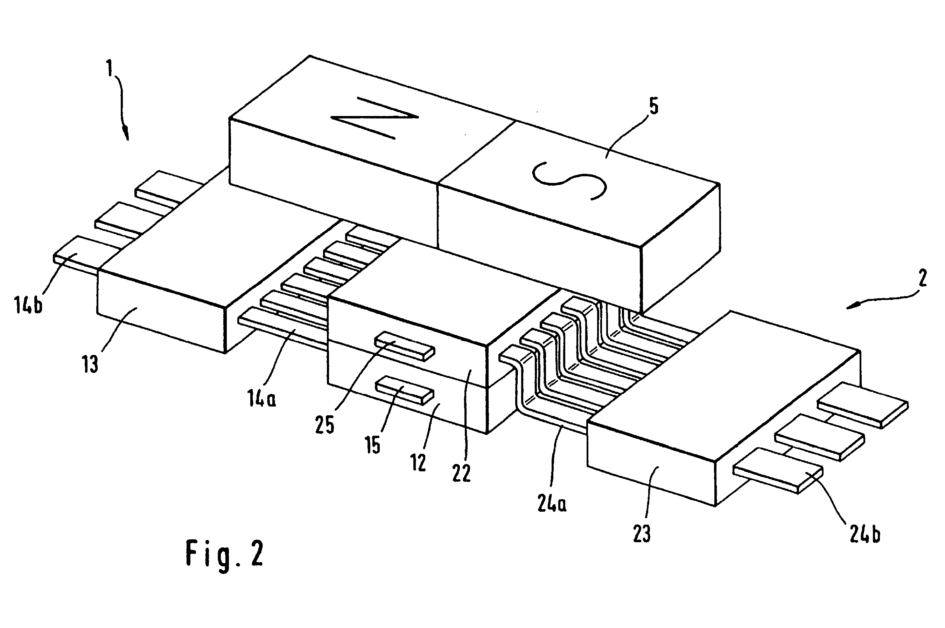

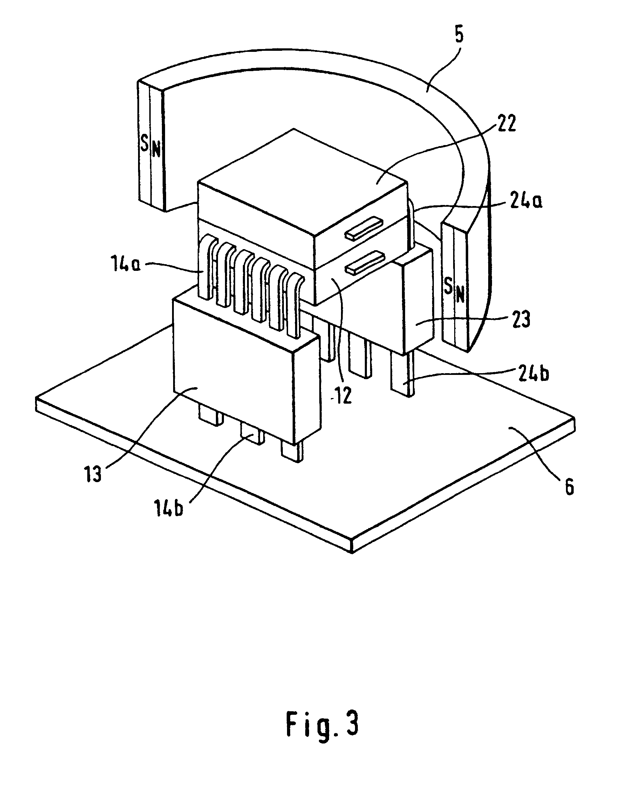

Aufgrund der Verbindung zwischen Sensor 12 und Auswerteelektronik 13 mittels des Stanzbiegeteiles 14a und 14b kann dieses Sensormodul 11 beliebig an den Einbauort angepaßt werden, in dem die Finger 14a zwischen Sensor 12 und Auswerteelektronik 13 gebogen werden, was am Beispiel von Figur 2 und 3 näher erläutert werden soll.

Ein redundantes System ist in Figur 2 dargestellt. Es besteht aus zwei Sensoreinheiten 1 und 2, welche identisch aufgebaut sind. Dabei besteht die Sensoreinheit 1 aus dem Sensor 12, den Verbindungen 14a, der Auswerteelektronik 13 sowie deren Anschlüssen 14b. Die zweite Sensoreinheit 2 besteht ebenfalls aus einem Sensor 22 und ist über die Blechstanzteile 24a mit der Auswerteelektronik 23 verbunden, welche wiederum Blechstanzteile 24b als Anschluß aufweist. Die beiden Sensoreinheiten 1 und 2 sind so angeordnet, dass die Sensoren 12 und 22 aufeinander liegen und die Auswerteelektroniken 13 bzw. 23 voneinander wegweisen.

Damit die Anschlüsse 14b bzw. 24b der beiden Sensoreinheiten einwandfrei in einer Ebene liegen, sind die Verbindungen 24a der zweiten Sensoreinheit 2 zwischen Sensor 22 und Auswerteschaltung 23 zweimal um annähernd 90 Grad gebogen.

Über den Sensoren 12, 22 erstreckt sich entsprechend der Längsrichtung der Sensoreinheiten 1, 2 ein Permanentmagnet 5, dessen Magnetfeld die Sensoren 12 und 22 durchsetzt, wobei die positionsabhängige Änderung des Magnetfeldes von den Sensoren 12 bzw. 22 erfaßt und als Ausgangssignal an die Auswerteschaltungen 13, 23 geliefert wird.

Eine weitere Darstellung des erfindungsgemäßen Moduls ist in Figur 3 dargestellt. Dabei ist der Dauermagnet 5 als zylindrischer Körper ausgebildet, wobei in der Figur 3 der Übersicht halber nur ein Teil dieses Magneten 5 dargestellt ist. Da die bekannten, zur Erfassung von Magnetfeldern verwendeten Sensoren 12 und 22, erst bei relativ hohen Feldstärken auswertbare Signale liefern, ist man auf die Verwendung von teuren Materialien bei der Herstellung des Permanentmagneten 5 angewiesen. Aus Kostengründen bemüht man sich den zylindrischen Magneten 5 so klein wie möglich zu halten. Im Zentrum des Magneten 5 sind die redundanten Sensoreinheiten 1, 2 angeordnet, welche aus den Sensoren 12 und 22 besteht, die ebenfalls übereinander liegend angeordnet sind. Außerhalb des Zentrums in Nähe der Wandung des Magneten 5 sind, sich gegenüberstehend parallel zur Achse des zylindrischen Magneten 5 die Auswerteeinheiten 13 bzw. 23 angeordnet, deren Ausgangsanschlüsse 14b bzw. 24b elektrisch mit einer Leiterplatte 6 verbunden sind. Die Blechstanzteile 14a bzw. 24a sind annähernd in Sensornähe 12, 22 um 90 Grad gebogen und machen so eine sehr kompakte kleine Sensoranordnung möglich, was die Kosten des gesamten Systems relevant senkt.

Je nach gewünschtem Anwendungsfall kann die Auswerteelektronik analoge oder digitale Ausgangssignale liefern, wobei die Auswerteelektronik zum Zwekke des Abgleichs der Brücken des Sensors und zur Festlegung des Anfangs und Endes des Meßbereichs programmierbar ist. Mit Hilfe der Auswerteelektronik ist neben Leitungs- und Kurzschluß zwischen Sensorkopf und Auswerteelektronik auch ein Verlust der Magnetfeldstärke detektierbar. Darüber hinaus sind nicht kompatible Sensorsignale feststellbar. Gleichzeitig ist eine Überwachung des Auswertealgorythmus möglich. Zusätzlich wird die Temperatur der Elektronik überwacht, die ihrerseits auslesbar ist.

Vorteilhafterweise können an die Anschlüsse 14b bzw. 24b weitere Leadframes, welche passive Bauelemente bzw. Steckelemente enthalten angebracht werden. Das Gesamtelement ist einfach umspritzbar bzw. in üblichen Fügetechniken wie US-E-Schweißen, Wellenlöten, Leitkleben, Reflowlöten bzw. Laserbearbeitung bearbeitbar.

## Patentansprüche

1. Sensormodul, bei welchem ein Positionssensor (12, 22) mit einer Auswerteelektronik (13, 23) verbunden ist, die das von dem Positionssensor abgegebene, der Lage eines Aktuators entsprechende Signal aufbereitet, **dadurch gekennzeichnet, dass** der Positionssensor (12, 22) und die Auswerteelektronik (13, 23) gemeinsam an oder auf einem Blechformteil (14a, 14b; 24a, 24b) angeordnet sind, wobei das Blechformteil (14a, 14b; 24a, 24b) mindestens zwischen Sensor (12, 22) und Auswerteelektronik (13, 23) zu deren elektrischen Verbindung als Leiterbahnstruktur (14a, 24a) ausgebildet ist, welche zur Anpassung an den Einbauort des Sensors(12, 22) abgewinkelt ist.

2. Sensormodul nach Anspruch 1 **dadurch gekennzeichnet, dass** der Sensor (12, 22) als magnetoresistiver Sensor ausgebildet ist, der in einem Magnetfeld angeordnet ist.

3. Sensormodul nach Anspruch 2 **dadurch gekennzeichnet, dass** der Sensor (12, 22) annähernd im Zentrum eines zylinderförmig ausgebildeten Dauermagneten (5) angeordnet ist.

4. Sensormodul nach Anspruch 1 oder 2 **dadurch gekennzeichnet, dass** der Sensor (12, 22) an einem ersten äußeren Ende des Blechformteiles (14a, 14b; 24a, 24b) arretiert ist, und dass das die Auswerteelektronik ( 13, 23) in eine dem Sensor (12, 22) entgegengesetzten Richtung überragende zweite Ende des Blechformteiles (14a, 14b; 24a, 24b) von mindestens einer frei endenden Leiterbahn (14b, 24b) gebildet ist.

5. Sensormodul nach Anspruch 4 **dadurch gekennzeichnet, dass** das freie Ende (14b, 24b) des Blechformteiles (14a, 14b; 24a, 24b) elektrisch mit einem zweiten, passive elektrische Bauelemente tragendem Blechformteil verbunden ist, an welchem eine Kontakteinrichtung ausgebildet ist.

6. Sensormodul nach Anspruch 5 **dadurch gekennzeichnet, dass** das erste und das zweite Blechformteil verschweißt oder verlötet sind.

7. Sensormodul nach Anspruch 4 oder 5 **dadurch gekennzeichnet, dass** die Kontakteinrichtung oder das freie Ende der Leiterbahn (14b, 24b) als Steckeinrichtung ausgebildet ist.

8. Sensormodul nach einem der Ansprüche 1 bis 5 **dadurch gekennzeichnet, dass** der Sensor (12, 22) und/oder die Auswerteelektronik (13, 23) separat gehäust sind.

9. Sensormodul nach einem der Ansprüche 1 bis 5 **dadurch gekennzeichnet, dass** eine erste und eine zweite identisch aufgebaute, jeweils aus einem Sensor (12; 22), einem Blechformteil (14a, 14b; 24a, 24b) und einer Auswertelektronik (13; 23) bestehende Sensoreinheit (1, 2) vorhanden sind, wobei das Blechformteil (14a, 14b; 24a, 24b) jeder Sensoreinheit zwischen Sensor und Auswerteelektronik um annähernd 90 Grad gebogen ist und die beiden Sensoreinheiten (1, 2) so in dem zylindrisch ausgebildeten Dauermagneten (5) eingeführt sind, dass die Sensoren (12; 22) unmittelbar übereinander liegend angeordnet sind, während die Auswerteelektroniken ( 13; 23) dezentral außerhalb der Sensorabmessungen angeordnet sind.

## Claims

1. Sensor module in which a position sensor (12, 22) is connected to an electronic evaluation unit (13, 23) which conditions the signal output by the position sensor and corresponding to the position of an actuator, **characterized in that** the position sensor (12, 22) and the electronic evaluation unit (13, 23) are jointly arranged at or on a shaped sheet-metal part (14a, 14b; 24a, 24b), the shaped sheet-metal part (14a, 14b; 24a, 24b) being designed as a conductor track structure (14a, 24a), at least between the sensor (12, 22) and an electronic evaluation unit (13, 23) for the purpose of an electric connection, which conductor track structure is angled off to adapt to the installation site of the sensor (12, 22).

2. Sensor module according to Claim 1, **characterized in that** the sensor (12, 22) is designed as a magnetoresistive sensor which is arranged in a magnetic field.

3. Sensor module according to Claim 2, **characterized in that** the sensor (12, 22) is arranged approximately at the centre of a cylindrically designed permanent magnet (5).

4. Sensor module according to Claim 1 or 2, **characterized in that** the sensor (12, 22) is positioned at a first outer end of the shaped sheet-metal part (14a, 14b; 24a, 24b), and **in that** the second end of the shaped sheet-metal part (14a, 14b; 24a, 24b), which project beyond the electronic evaluation unit (13, 23) in the opposite direction to the sensor (12, 22), is formed by at least one freely ending conductor track (14b, 24b).

5. Sensor module according to Claim 4, **characterized in that** the free end (14b, 24b) of the shaped sheet-metal part (14a, 14b; 24a, 24b) is electrically connected to a second shaped sheet-metal part, which supports passive electric components and on which a contact device is constructed.

6. Sensor module according to Claim 5, **characterized in that** the first and the second shaped sheet-metal parts are welded or soldered.

7. Sensor module according to Claim 4 or 5, **characterized in that** the contact device or the free end of the conductor track (14b, 24b) is constructed as a plug-in device.

8. Sensor module according to one of Claims 1 to 5, **characterized in that** the sensor (12, 22) and/or the electronic evaluation unit (13, 23) are separately housed.

9. Sensor module according to one of Claims 1 to 5, **characterized in that** a first and a second identically constructed sensor unit (1, 2) respectively consisting of a sensor (12; 22), a shaped sheet-metal part (14a, 14b; 24a, 24b) and an electronic evaluation unit (13; 23) are present, the shaped sheet-metal part (14a, 14b; 24a, 24b) of each sensor unit being bent by approximately 90 degrees between the sensor and electronic evaluation unit, and the two sensor units (1, 2) being inserted into the cylindrically designed permanent magnet (5) such that the sensors (12; 22) are arranged lying immediately one above another, while the electronic evaluation units (13; 23) are arranged decentrally outside the sensor dimensions.

## Revendications

1. Module de capteur, dans lequel un capteur de position (12, 22) est relié à une électronique d'évaluation (13, 23), qui met en forme le signal délivré par le capteur de position correspondant à la position d'un acteur, **caractérisé par le fait que** le capteur de position (12, 22) et l'électronique d'évaluation (13, 23) sont montés ensemble à ou sur une pièce usinée en tôle (14a, 14b; 24a, 24b), la pièce usinée en tôle (14a, 14b; 24a, 24b) étant au moins conçue, entre le capteur (12, 22) et l'électronique d'évaluation (13, 23), pour les relier électriquement sous la forme d'une structure à pistes conductrices (14a, 24a), qui est coudée pour l'adapter au lieu d'installation du capteur (12, 22).

2. Module de capteur selon la revendication 1 **caractérisé par le fait que** le capteur (12, 22) est conçu comme capteur magnéto-résistif disposé dans un champ magnétique.

3. Module de capteur selon la revendication 2 **caractérisé par le fait que** le capteur (12, 22) est disposé approximativement au centre d'un aimant permanent (5) cylindrique.

4. Module de capteur selon la revendication 1 ou 2 **caractérisé par le fait que** le capteur (12, 22) est fixé à une première extrémité extérieure de la pièce usinée en tôle (14a, 14b; 24a, 24b) et que la deuxième extrémité de la pièce usinée en tôle (14a, 14b; 24a, 24b) dépassant de l'électronique d'évaluation (13, 23) dans une direction opposée au capteur (12, 22) est formée par au moins une piste conductrice (14b, 24b) se terminant librement.

5. Module de capteur selon la revendication 4 **caractérisé par le fait que** l'extrémité libre (14b, 24b) de la pièce usinée en tôle (14a, 14b; 24a, 24b) est reliée électriquement à une deuxième pièce usinée en tôle, qui porte des composants électriques passifs, sur laquelle est formé un dispositif de mise en contact.

6. Module de capteur selon la revendication 5 **caractérisé par le fait que** la première et la deuxième pièce usinée en tôle sont soudées ou brasées.

7. Module de capteur selon la revendication 4 ou 5 **caractérisé par le fait que** le dispositif de mise en contact ou l'extrémité libre de la piste conductrice (14b, 24b) sont conçus comme dispositif enfichable.

8. Module de capteur selon l'une des revendications 1 à 5 **caractérisé par le fait que** le capteur (12, 22) et/ou l'électronique d'évaluation (13, 23) sont logés dans des boîtiers séparés.

9. Module de capteur selon l'une des revendications 1 à 5 **caractérisé par le fait qu'**il renferme une première et une deuxième unité de captage (1, 2), constituées d'une façon identique chacune d'un capteur (12; 22), d'une pièce usinée en tôle (14a, 14b; 24a, 24b) et d'une électronique d'évaluation (13; 23), la pièce usinée en tôle (14a, 14b; 24a, 24b) de chaque unité de captage étant pliée approximativement à 90 degrés entre le capteur et l'électronique d'évaluation et les deux unités de captage (1, 2) étant engagées dans l'aimant permanent (5), conçu sous une forme cylindrique, de telle manière que les capteurs (12; 22) sont disposés directement l'un au-dessus de l'autre, alors que les électroniques d'évaluation (13; 23) sont disposées d'une façon décentralisée au-delà des dimensions des capteurs.
